# EUROPÄISCHE PATENTSCHRIFT

(11) **EP 2 811 248 B1**
(45) Veröffentlichungstag und Bekanntmachung des Hinweises auf die Patenterteilung: **08.05.2019**
(21) Anmeldenummer: 13170747.3
(22) Anmeldetag: 06.06.2013
(51) Int. Cl.: F27D 19/00, F27D 21/00, F27D 99/00, G01R 27/18, H02H 3/00

(54) **Isolationsüberwachung eines elektrischen Heizkreises für einen Schmelzofen und Verfahren zur Überwachung**
Insulation monitoring of an electrical heating circuit for a melting furnace and method for monitoring
Surveillance de l'isolation d'un circuit de chauffage électrique pour un four de fusion et procédé de surveillance

(43) Veröffentlichungstag der Anmeldung: 10.12.2014
(73) Patentinhaber: Siemens Aktiengesellschaft, 80333 München (DE)
(72) Erfinder: Baumbach, Uwe, 08066 Zwickau (DE); Weiss, Jörg, 09224 Chemnitz (DE)

(56) Entgegenhaltungen:
- DE-A1- 2 515 121
- DE-A1- 3 513 846
- DE-A1- 3 941 975
- DE-A1- 4 109 586
- DE-C1- 19 505 814
- JP-A- H04 165 289
- JP-A- 2003 322 481

## Beschreibung

Die Erfindung betrifft eine Isolationsüberwachung für einen elektrischen Heizkreis eines Schmelzofens.

Bei Schmelzöfen, insbesondere bei industriellen Metall-/ Halbleiter-Schmelzöfen ist eine Isolationsüberwachung eines elektrischen Heizkreises vorteilhaft. Dabei können ein oder mehrere Heizkreise überwacht werden. Insbesondere stellt die Isolationsüberwachung gegenüber einem Erdpotential eine Erdschlussüberwachung dar.

Zum Aufschmelzen einer Einwaage in einer Tiegelheizung, insbesondere in einer Kristallzüchtungsanlage, z.B. bei dem Czochralski-Verfahren, wird üblicherweise ein niederohmiger Graphitheizer eingesetzt. Die hierfür benötigte Heizleistung wird beispielsweise mittels Stellgliedern (Thyristorsteller) bereitgestellt, welche nach dem Prinzip der Phasenanschnittsteuerung arbeiten. Die Stromversorgungsvorrichtung weist einen Netzeingang und einen oder mehrere Gleichspannungsausgänge auf.

Ein Heizkreis bzw. mehrere Heizkreise einer Heizung eines Schmelzofens werden beispielsweise mit Wechselstrom und/oder mit Gleichstrom betrieben. Zur Erzeugung der Ströme werden insbesondere elektronischen Stellgliedern verwendet. Die Erzeugung bzw. Regelung der Spannung erfolgt beispielsweise mittels eines Schaltnetzteiles oder eines Thyristorstellers. Zur EMV-Entstörung können diese Ableitkapazitäten eingebaut haben. Im Schmelzofen kann es zur Ausbildung einer leitfähigen Atmosphäre beispielsweise durch Metall-/Halbleiterdämpfe und Ionisationseffekte kommen. Dies führt dazu, dass hohe Anforderungen an eine Isolationsüberwachung zu stellen sind. Dies liegt insbesondere an hohen Ableitströmen, welche zu Problemen bei herkömmlichen Isolationswächtern führen können.

Durch komplexe Messverfahren mit hohen Messzeitkonstanten, was eine hohe Ansprechzeit zur Folge hat, kann versucht werden eine Überwachung zu realisieren. Bei einer Ableitkapazität von >100uF kann mit einer Ansprechzeit von >30s gerechnet werden. Isolationswächter sind derart ausgestaltbar, dass diese in der Lage sind einen symmetrischen Erdschluss zu erkennen. Wird zur Überwachung der Isolationswiderstand verwendet, ist die Messung des Isolationswiderstandes aufgrund der leitfähigen Atmosphäre gegebenenfalls nur vor Prozessbeginn im Rahmen eines Anlagentests möglich und nicht mehr während des Betriebes der Anlage zum Schmelzen.

Isolationsüberwachungen werden in verschiedenen technischen Gebieten eingesetzt. Aus der DE 41 09 586 A1 ist eine Schaltungsanordnung zur Isolationsüberwachung in angeerdeten Niederspannungsnetzen bekannt.

Aus der JP 04-165289 ist ein Isolationswächter für einen Lichtbogenofen bekannt und aus der JP 2003-322481 ein Widerstandsmessgerät für eine Isoliermuffe bei einem Schmelzofen.

Eine Aufgabe der Erfindung besteht darin, die obig genannten Nachteile zu vermeiden oder zu vermindern, bzw. eine einfache Isolationsüberwachung bei einem Schmelzofen zu ermöglichen.

Die Lösung dieser Aufgabe gelingt bei einer Isolationsüberwachung, bzw. bei einem Verfahren zur Isolationsüberwachung eines Heizkreises gemäß einem der Ansprüche 1 bis 9.

Bei einer Isolationsüberwachung eines elektrischen Heizkreises für einen Schmelzofen sind ein Spannungsteiler und eine Spannungsüberwachung für den Spannungsteiler vorgesehen. Der Heizkreis dient zur Erwärmung des Schmelzofens, insbesondere zur Erwärmung eines Schmelzgutes im Schmelzofen. Der Spannungsteiler ist ein ohmscher ohmsch-induktiver oder ohmsch-kapazitiver Spannungsteiler.

Damit ist eine insbesondere kontinuierliche Überwachung während des Betriebs des Schmelzofens (also während des Anlagenbetriebs des Schmelzofens) möglich. Dies betrifft insbesondere eine Überwachung auf einen unsymmetrischen Erdschluss. Da der Betrieb des Schmelzofens z.T. über mehrere Tage oder gar Wochen und Monate hinweg andauern kann, ist diese stetige Überwachung umso wichtiger. Die Isolationsüberwachung ist also auch im Betrieb des Schmelzofens durchführbar. Für das Erkennen eines symmetrischen Erdschlusses sind weitere Mittel zur Überwachung vorzusehen.

Zum Betrieb des Schmelzofens ist eine speisende Quelle (Stromversorgung) vorgesehen. Durch die in der Anlage des Schmelzofens und als ein Bestandteil der speisenden Quelle vorhandenen Kondensatoren und/oder parasitären Kapazitäten ergibt sich eine Ableitkapazität gegen Erde (PE). Dies kann in einem Ersatzschaltbild durch Kapazitäten C1 und C2 repräsentiert werden. Bei Abwesenheit eines Spannungsteilers, welcher insbesondere durch Widerstände aufgebaut ist (Widerstand R1 und R2) würde sich je nach Verhältnis von C1 und C2 die Spannung am Ausgang der Quelle entsprechend bekannter Formel aufteilen: U1/U2 = C2/C1.

Die Heizung lässt sich in einem Ersatzschaltbild durch einen Lastwiderstand R_{Last} symbolisieren. Ein in einem Fehlerfall vorhandener Erdschluss lässt sich mit einem entsprechenden Übergangswiderstand gegen PE (protection earth) durch einen Widerstand R_{F} symbolisieren. Die Ausgangsspannung der Energie-Quelle (symbolisierbar durch eine idealisierte Spannungs- bzw. Stromquelle) lässt sich insbesondere durch einen geerdeten Spannungsteiler gezielt aufteilen.

Der Spannungsteiler kann auch als ohmsch-induktiver oder als ohmsch-kapazitiver Spannungsteiler realisiert sein.

In einer Ausgestaltung der Isolationsüberwachung ist der Spannungsteiler ein symmetrischer Spannungsteiler. Eine Isolationsüberwachung ist aber auch mittels eines asymmetrischen Spannungsteilers realisierbar. Bei einer symmetrischen Aufteilung ist insbesondere R1 = R2. Eine Asymmetrie besteht insbesondere bei R1 ≠ R2.

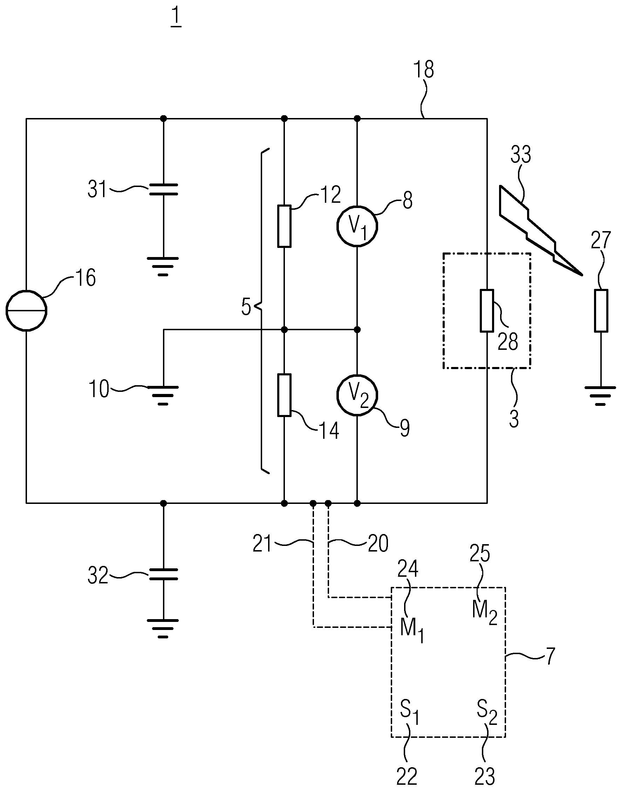

In einer Ausführungsform der Isolationsüberwachung werden Spannungen über den Spannungsteiler gemessen und/oder überwacht. Überwacht werden also z.B. die Spannungen U1 und U2. Beispielsweise wird dann im Falle eines einpoligen Erdschlusses der Spannungsteiler R1/R2 verfälscht und die gemessenen Spannungen U1 und U2 ändern ihr Verhältnis zueinander, gegenüber dem ursprünglichen fehlerfreien Zustand. Diese Tatsache dient zur Fehlerdetektierung. Dieses Prinzip kann insbesondere in Hinblick auf die Figur nachvollzogen werden.

In einer Ausgestaltung der Isolationsüberwachung weisen die Spannungsmesser und der Spannungsteiler ein Bezugspotential auf, wobei dieses insbesondere ein gemeinsames Bezugspotential ist. Als Bezugspotential kann insbesondere PE verwendet sein.

In einer Ausgestaltung der Isolationsüberwachung weist der Spannungsteiler einen ersten Widerstand und einen zweiten Widerstand auf. Der erste und zweite Widerstand kann sich insbesondere aus einer Vielzahl von parallel oder seriell verschalteten Einzelwiderständen zusammensetzen. Der erste Widerstand ist mit dem zweiten Widerstand seriell verschaltet, wobei der Spannungsteiler parallel zu einer Energieversorgung für den Heizkreis geschaltet ist. Dabei weist der Heizkreis zumindest ein Heizelement für den Ofen auf. Der erste Widerstand und der zweite Widerstand weisen ein gemeinsames Potential auf, welches mit einem Erdpotential verbunden ist. Die Spannungsüberwachung weist eine erste Messeinrichtung und eine zweite Messeinrichtung auf, wobei die erste Messeinrichtung zum ersten Widerstand parallel geschaltet ist, und wobei die zweite Messeinrichtung zum zweiten Widerstand parallel geschaltet ist.

In einer Ausgestaltung der Isolationsüberwachung kann die Messung und/oder Auswertung der Spannungen des Spannungsteilers (U1 und U2) über eine, meist in der Anlage sowieso vorhandene, SPS (Speicherprogrammierbare Steuerung) mittels analoger Eingange realisiert werden. Ein bisher separat verwendeter Isolationswächter ist dann ggf. nicht mehr erforderlich (je nach Applikation und Normenlage).

Wird vor dem Start der Anlage oder im Wartungsfall eine echte Isolationsmessung trotzdem zusätzlich gefordert, so kann auch insbesondere eine der obig beschriebenen Schaltungen zur Überwachung optional mittels eines Schaltelementes (insbesondere mittels eines Relais, Schützes, Schalters etc.) während der Isolationsmessung vom elektrischen Heizkreis entkoppelt werden.

Mittels der beschriebenen Isolationsüberwachung, welche insbesondere auch als eine Erdschlussüberwachung zu betrachten ist, kann ein separater Erdschlusswächter durch einen Widerstandsteiler ersetzt werden. Die Spannungen über den Widerstandsteiler können beispielsweise über Eingänge einer SPS, einer Antriebsregelung oder dergleichen erfasst und insbesondere ausgewertet werden. Als Eingang kann ein Analogeingang oder auch ein Digitaleingang dienen, was insbesondere vom Messgerät für die Spannung abhängt. Messwerte der Spannung können beispielsweise auch über einen Digitalbus übertragen werden. Die Schaltung des Spannungsteilers kann durch Dimensionierung der Widerstände R1 und R2 leicht an eine Anlage angepasst werden. Dies hat den Vorteil, dass die Überwachung einfach an eine Anlage mit hohen Netzableitkapazitäten angepasst werden kann. Werden die Widerstandswerte für R1 und R2 entsprechend gewählt, so ist auch bei einer leitfähigen Atmosphäre durch Metall- bzw. Halbleiterdämpfe bzw. bei Ionisation eine Überwachung während des Prozesses möglich. Es kann auch der zeitliche Verlauf der Veränderung des Isolationswiderstandes ermittelt werden. Insbesondere bei schwankendem Ionisationsgrad (Leitwert der Atmosphäre) während des zeitlichen Prozessverlaufes bleibt das Verhältnis der gemessenen Spannungen U1 und U2 theoretisch konstant. Praktisch ergibt sich eine gewisse Schwankungsbreite, d.h. eine Fehlerschwelle ist auf die jeweilige Applikation anzupassen.

In einer Ausgestaltung der Isolationsüberwachung weist diese eine anpassbare Fehlerschwelle auf. Die Fehlerschwelle wird insbesondere automatisch abhängig von den Werten des verwendeten Spannungsteilers und/oder abhängig von dem vorzunehmenden Schmelzvorgang verändert. Auch eine zeitliche Veränderung der Fehlerschwelle während des zeitlichen Verlaufes des Schmelzvorgangs ist vorsehbar.

In weiteren Ausgestaltungen der Überwachung sind die Spannungsmessungen von U1, U2 und/oder die Auswertung mit einer vorhandenen Prozessleittechnik möglich. Insbesondere ist ein nahezu verzögerungsfreies (nur abhängig von Störglättung und Verarbeitungsgeschwindigkeit der Prozess-SPS) Auslöseverhalten in der SPS programmierbar. Dies alles trägt zu der Möglichkeit bei, eine preiswerte und robuste Isolationsüberwachung zu realisieren.

In einer Ausgestaltung der Isolationsüberwachung ist der Spannungsteiler und/oder die zugehörigen Messeinrichtungen mittels eines Schaltelementes vom Heizkreis und/oder vom gemeinsamen Potential entkoppelbar. Das Schaltelement ist beispielsweise ein Schütz oder ein Relais oder ein Leistungsschalter oder eine Kombination hieraus.

In einem isolationsüberwachten Heizkreis eines Schmelzofens ist eine Isolationsüberwachung der obig beschriebenen Art einsetzbar. In einer Ausgestaltung eines isolationsüberwachten Heizkreises eines Schmelzofens, sind ein Spannungsteiler und eine Spannungsüberwachung vorgesehen, wobei der Spannungsteiler einen ersten Widerstand und einen zweiten Widerstand aufweist, wobei der erste Widerstand mit dem zweiten Widerstand seriell verschaltet ist, wobei der Spannungsteiler parallel zu einer Energieversorgung (Energieversorgungsquelle) für den Heizkreis geschaltet ist, wobei der erste Widerstand und der zweite Widerstand ein gemeinsames Potential aufweisen, welches mit einem Erdpotential verbunden ist, wobei die Spannungsüberwachung eine erste Messeinrichtung und eine zweite Messeinrichtung aufweist, wobei die erste Messeinrichtung zum ersten Widerstand parallel geschaltet ist, und wobei die zweite Messeinrichtung zum zweiten Widerstand parallel geschaltet ist.

Bei einem Verfahren zur Isolationsüberwachung eines Heizkreises eines Schmelzofens, sind ein Spannungsteiler und eine Spannungsüberwachung vorgesehen, wobei der Spannungsteiler einen ersten Widerstand und einen zweiten Widerstand aufweist, wobei der erste Widerstand mit dem zweiten Widerstand seriell verschaltet ist, wobei der Spannungsteiler parallel zu einer Energieversorgung für den Heizkreis geschaltet ist, wobei der erste Widerstand und der zweite Widerstand ein gemeinsames Potential aufweisen, welches mit einem Erdpotential verbunden ist, wobei die Spannungsüberwachung eine erste Messeinrichtung und eine zweite Messeinrichtung aufweist, wobei die erste Messeinrichtung zum ersten Widerstand parallel geschaltet ist, und wobei die zweite Messeinrichtung zum zweiten Widerstand parallel geschaltet ist, wobei ein erstes Messsignal der ersten Messeinrichtung und ein zweites Messsignal der zweiten Messeinrichtung in einer Auswerteeinrichtung ausgewertet wird. Dabei wird insbesondere bei Überschreitung und/oder einem Erreichen eines Schwellwertes ein Meldesignal generiert, wobei der Schwellwert insbesondere abänderbar ist. In einer Ausgestaltung des Verfahrens wird der Schwellwert automatisch abhängig vom Schmelzprozess abgeändert.

In einer Ausgestaltung des Verfahrens werden die Messsignale der ersten und zweiten Messeinrichtung mit Sollwerten verglichen. Der Vergleich erfolgt insbesondere mittels einer Generierung einer Differenz zwischen Sollwerten und Istwerten und einem Vergleich mit einem Schwellwert.

In einer Ausgestaltung des Verfahrens werden die Messsignale über die Zeit gespeichert und der zeitliche Verlauf der Messsignale ausgewertet.

In einer Ausgestaltung des Verfahrens wird als Auswerteeinrichtung eine Speicherprogrammierbare Steuerung oder eine Regelungseinrichtung verwendet, welche auch für die Temperaturregulierung des Schmelzofens verwendet wird.

Nachfolgend wird ein Ausführungsbeispiel der Erfindung anhand der Zeichnung näher erläutert. Die Figur zeigt ein Ersatzschaltbild eines Heizkreises mit weiteren Elementen.

Die Darstellung gemäß der Figur zeigt eine Isolationsüberwachung 1 eines elektrischen Heizkreises 18 für einen Schmelzofen 3, wobei ein Spannungsteiler 5 und eine Spannungsüberwachung für den Spannungsteiler 5 vorgesehen ist. Der Spannungsteiler 5 ist ein ohmscher Spannungsteiler mit einem ersten Widerstand R1 12 und eine zweiten Widerstand R2 14, wobei die Widerstände 12, 14 seriell verschalten sind. Der Spannungsteiler 5 ist parallel zu einer Energieversorgung 16 verschaltet. Die Energieversorgung 16 ist als idealisierte Spannungs- bzw. Stromquelle dargestellt. Parallel zum Widerstand R1 12 ist eine erste Messeinrichtung V1 8 zur Messung einer Spannung U1 verschaltet. Parallel zum Widerstand R2 14 ist eine zweite Messeinrichtung V2 9 zur Messung einer Spannung U2 verschaltet. Die gemessenen Spannungen U1 und U2 werden über Signalwege 21 und 22 zu einer Auswerteeinrichtung 7 geführt. Dort werden die gemessenen Spannungen als Messwerte M1 24 und M2 25 gespeichert und mit Sollwerten S1 22 und S2 23 in Relation gesetzt bzw. verglichen. Damit ist es möglich einen Erdschluss 33 zu detektieren.

Durch die in der Anlage des Schmelzofens 3 und als ein Bestandteil der speisenden Energieversorgung (Energiequelle) 16 vorhandenen Kondensatoren und/oder parasitären Kapazitäten ergibt sich eine Ableitkapazität gegen Erde (PE). In der Figur ist dies durch die Elemente C1 31 und C2 32 repräsentiert. Die Heizung ist in der Figur durch den Lastwiderstand R_{Last} 28 symbolisiert. Der im Fehlerfalle vorhandene Erdschluss 33 mit einem entsprechendem Übergangswiderstand gegen PE ist durch den Widerstand R_{F} 27 dargestellt. Die Ausgangsspannung der Energiequelle 16 (symbolisiert durch eine idealisierte Spannungs- bzw. Stromquelle) lässt sich insbesondere durch einen geerdeten Spannungsteiler 5 gezielt gegen Erde aufteilen. Gemäß der Figur weisen der Spannungsteiler 5 und die Messeinrichtungen 8, 9 ein gemeinsames Erdpotential 10 auf.

## Patentansprüche

1. Isolationsüberwachung (1) eines elektrischen Heizkreises eines Schmelzofens (3), mit einem Spannungsteiler (5) und einer Spannungsüberwachung mit Spannungsmessern (8,9) für den Spannungsteiler (5), wobei der Spannungsteiler (5) ein ohmscher oder ohmsch-induktiver oder ohmsch-kapazitiver Spannungsteiler ist, wobei die Spannungsmesser (8,9) und Spannungsteiler (5) ein Bezugspotential (10) aufweisen, wobei der Spannungsteiler (5) einen ersten Widerstand (12) und einen zweiten Widerstand (14) aufweist, wobei der erste Widerstand (12) mit dem zweiten Widerstand (14) seriell verschaltet ist, wobei der Spannungsteiler (5) parallel zu einer Energieversorgung (16) für den Heizkreis (18) geschaltet ist, wobei der erste Widerstand (12) und der zweite Widerstand (14) ein gemeinsames Potential (10) aufweisen, welches mit einem Erdpotential (10) verbunden ist, wobei die Spannungsüberwachung eine erste Messeinrichtung (8) und eine zweite Messeinrichtung (9) aufweist, wobei die erste Messeinrichtung (8) zum ersten Widerstand (12) parallel geschaltet ist, und wobei die zweite Messeinrichtung (9) zum zweiten Widerstand (14) parallel geschaltet ist.

2. Isolationsüberwachung (1) nach Anspruch 1, wobei der Spannungsteiler (5) ein symmetrischer Spannungsteiler ist.

3. Isolationsüberwachung (1) nach Anspruch 1 oder 2, wobei der Spannungsteiler (5) ein asymmetrischer Spannungsteiler ist.

4. Isolationsüberwachung (1) nach einem der Ansprüche 1 bis 3, wobei der Spannungsteiler (5) und/oder die zugehörigen Messeinrichtungen (8,9) mittels eines Schaltelementes vom Heizkreis (18) und/oder vom gemeinsamen Potential (10) entkoppelbar sind.

5. Verfahren zur Isolationsüberwachung eines Heizkreises (18) eines Schmelzofens (3), wobei eine Isolationsüberwachung (1) nach einem der Ansprüche 1 bis 4 verwendet wird, wobei ein erstes Messsignal der ersten Messeinrichtung (8) und ein zweites Messsignal der zweiten Messeinrichtung (9) in einer Auswerteeinrichtung (7) ausgewertet wird.

6. Verfahren nach Anspruch 5, wobei die Messsignale (24, 25) der ersten und zweiten Messeinrichtung (8,9) mit Sollwerten (22, 23) verglichen werden.

7. Verfahren nach Anspruch 5 oder 6, wobei die Messsignale (24, 25) über die Zeit gespeichert werden und der zeitliche Verlauf der Messsignale (24, 25) ausgewertet wird.

8. Verfahren nach einem der Ansprüche 5 bis 8, wobei die Auswerteeinrichtung (7) eine Speicherprogrammierbare Steuerung oder eine Regelungseinrichtung ist, welche auch für die Temperaturregulierung des Schmelzofens (3) verwendet wird.

9. Verfahren nach Anspruch 5, wobei vor dem Start des Schmelzofens (3) oder in einem Wartungsfall der Spannungsteiler (5) und/oder die zugehörigen Messeinrichtungen (8,9) mittels eines Schaltelementes vom Heizkreis (18) und/oder vom gemeinsamen Potential (10) entkoppelt sind.

## Claims

1. Insulation monitoring (1) of an electrical heating circuit of a melting furnace (3), having a voltage divider (5) and a voltage monitoring with voltage meters (8, 9) for the voltage divider (5), wherein the voltage divider (5) is an ohmic or ohmic-inductive or ohmic-capacitive voltage divider, wherein the voltage meter (8, 9) and voltage divider (5) have a reference potential (10), wherein the voltage divider (5) has a first resistance (12) and a second resistance (14), wherein the first resistance (12) is connected in series with the second resistance (14), wherein the voltage divider (5) is connected in parallel with a power supply (16) for the heating circuit (18), wherein the first resistance (12) and the second resistance (14) have a shared potential (10) which is connected to an earth potential (10), wherein the voltage monitoring has a first measuring device (8) and a second measuring device (9), wherein the first measuring device (8) is connected in parallel with the first resistance (12) and wherein the second measuring device (9) is connected in parallel with the second resistance (14).

2. Insulation monitoring (1) according to claim 1, wherein the voltage divider (5) is a symmetrical voltage divider.

3. Insulation monitoring (1) according to claim 1 or 2, wherein the voltage divider (5) is an asymmetrical voltage divider.

4. Insulation monitoring (1) according to one of claims 1 to 3, wherein the voltage divider (5) and/or the associated measuring devices (8, 9) can be decoupled from the heating circuit (18) and/or from the shared potential (10) by means of a switching element.

5. Method for insulation monitoring of a heating circuit (18) of a furnace oven (3), wherein an insulation monitoring (1) according to one of claims 1 to 4 is used, wherein a first measuring signal of the first measuring device (8) and a second measuring signal of the second measuring device (9) is evaluated in an evaluation device (7).

6. Method according to claim 5, wherein the measuring signals (24, 25) of the first and second measuring device (8, 9) are compared with target values (22, 23).

7. Method according to claim 5 or 6, wherein the measuring signals (24, 25) are stored over time and the time curve of the measuring signals (24, 25) is evaluated.

8. Method according to one of claims 5 to 8, wherein the evaluation device (7) is a programmable logic controller or a control system which is also used to control the temperature of the furnace oven (3).

9. Method according to claim 5, wherein prior to the start of the furnace oven (3) or in the event of maintenance the voltage divider (5) and/or the associated measuring devices (8, 9) are decoupled from the heating circuit (18) and/or from the shared potential (10) by means of a switching element.

## Revendications

1. Contrôle (1) de l'isolation d'un circuit électrique de chauffage d'un four (3) de fusion, comprenant un diviseur (5) de tension et un contrôle de tension avec des voltmètres (8, 9) pour le diviseur (5) de tension, le diviseur (5) de tension étant un diviseur de tension ohmique ou ohmique-inductif ou ohmique-capacitif, les voltmètres (8, 9) et le diviseur (5) de tension ayant un potentiel (10) de référence, le diviseur (5) de tension ayant une première résistance (12) et une deuxième résistance (14), la première résistance (12) étant montée en série avec la deuxième résistance (14), le diviseur (5) de tension étant monté en parallèle avec une alimentation (16) en énergie du circuit (18) de chauffage, la première résistance (12) et la deuxième résistance (14) ayant un potentiel (10) commun, qui est relié à un potentiel (10) de terre, le contrôle de tension ayant un premier dispositif (8) de mesure et un deuxième dispositif (9) de mesure, le premier dispositif (8) de mesure étant monté en parallèle avec la première résistance (12), et le deuxième dispositif (9) de mesure étant monté en parallèle avec la deuxième résistance (14).

2. Contrôle (1) d'isolation suivant la revendication 1, dans lequel le diviseur (5) de tension est un diviseur de tension symétrique.

3. Contrôle (1) d'isolation suivant la revendication 1 ou 2, dans lequel le diviseur (5) de tension est un diviseur de tension dissymétrique.

4. Contrôle (1) d'isolation suivant l'une des revendications 1 à 3, dans lequel le diviseur (5) de tension et/ou les dispositifs (8, 9) de mesure associés peuvent, au moyen d'un élément de commutation, être découplés du circuit (18) de chauffage et/ou du potentiel (10) commun.

5. Procédé de contrôle d'isolation d'un circuit (18) de chauffage d'un four (3) de fusion, dans lequel on utilise un contrôle (1) d'isolation suivant l'une des revendications 1 à 4, dans lequel on exploite un premier signal de mesure du premier dispositif (8) de mesure et un deuxième signal de mesure du deuxième dispositif (9) de mesure dans un dispositif (7) d'exploitation.

6. Procédé suivant la revendication 5, dans lequel on compare les signaux (24, 25) de mesure du premier et du deuxième dispositifs (8, 9) de mesure à des valeurs (22, 23) de consigne.

7. Procédé suivant la revendication 5 ou 6, dans lequel on mémorise les signaux (24, 25) de mesure en fonction du temps et on exploite la variation des signaux (24, 25) de mesure en fonction du temps.

8. Procédé suivant l'une des revendications 5 à 8, dans lequel le dispositif (7) d'exploitation est un automate programmable ou un dispositif de régulation, qui est utilisé également pour la régulation de la température du four (3) de fusion.

9. Procédé suivant la revendication 5, dans lequel, avant le démarrage du four (3) de fusion ou en cas d'entretien, on découple le diviseur (5) de tension et/ou les dispositifs (8, 9) de mesure associés au moyen d'un élément de commutation du circuit (18) de chauffage et/ou du potentiel (10) commun.
